# EUROPÄISCHE PATENTANMELDUNG

(11) **EP 1 737 028 A2**
(43) Veröffentlichungstag der Anmeldung: **27.12.2006**
(21) Anmeldenummer: 06013081.2
(22) Anmeldetag: 26.06.2006
(51) Int. Cl.: H01L 21/336, H01L 29/423, H01L 29/49

(54) **Feldeffekttransistor und Verfahren zur Herstellung eines Feldeffekttransistors**

(30) Priorität: 25.06.2005 DE 102005028837
(71) Anmelder: ATMEL Germany GmbH, 74072 Heilbronn (DE)
(72) Erfinder: Joodaki, Mojtaba, Dr., 81735 München (DE)

(57) **Zusammenfassung**

Feldeffekttransistor mit
- einem Gate-Oxid (60, 60', 60")
- einer auf dem Gate-Oxid (60) aufgebrachten polykristallinen Schicht (40), und
- zumindest einem Spacer (51, 53) aus polykristallinem Silizium, bei dem
- der zumindest eine Spacer (51, 53) mit der auf dem Gate-Oxid (60) aufgebrachten polykristallinen Schicht (40) leitend verbunden ist,
- das Gate-Oxid (60) eine erste Dicke in einem ersten Bereich (62) unterhalb der polykristallinen Siliziumschicht (40) und eine zweite Dicke in einem zweiten Bereich (61, 63) unterhalb des zumindest einen Spacers (51, 53) aufweist, und
- die zweite Dicke des Gate-Oxids (60', 60") in dem zweiten Bereich (61, 63) gegenüber der ersten Dicke des Gate-Oxids (60) in dem ersten Bereich (62) reduziert ist.

## Beschreibung

Die vorliegende Erfindung betrifft einen Feldeffekttransistor und ein Verfahren zur Herstellung eines Feldeffekttransistors.

Aus der US 6,225,669 B1 und der DE 199 46 435 A1 sind Feldeffekttransistoren mit so genannten Spacern aus einem Dielektrikum bekannt. Diese werden durch Rückätzen einer dielektrischen Schicht beispielsweise aus Si₃N₄ oder SiO₂ erzeugt. In nicht-flüchtigen Speicherzellen werden Spacer aus polykristallinem Silizium eingesetzt, die von der Gateelektrode durch eine so genannte ONO-Schicht isoliert sind und daher auch als Floating Gate bezeichnet werden. Durch ein Tunneloxid können Elektronen in die polykristallinen Spacer tunneln und so die Speicherzelle beispielsweise programmieren. Der Kanal ist dabei sowohl unter der Gateelektrode als auch unter dem Floating Gate ausgebildet.

In IEEE Trans. on electron devices, vol. 47, no. 4, April 2000 ist in "Device Scaling Effects on Hot-Carreier Induced Interface and Oxide-Trapped Charge Distributions in MOSFET's" angegeben, dass das Maximum der Verteilung von so genannten heißen Ladungsträgern und im Gate-Oxid gefangenen Ladungen für unterschiedliche Gate-Längen und Dicken des Gate-Oxids innerhalb von 20 nm von dem Drain-PN-Übergang auftritt. Dies ist analysiert für einen MOSFET (Metall-Oxid-Semiconductor-Field-Effect-Transistor) mit einer LDD (Lightly Doped Drain) Struktur.

Eine Analytik von MOSFETs mit einer LDD-Struktur sind ebenfalls in IEEE Trans. on electron devices, vol. 47, no. 1, January 2000, "MOSFET channel Length: Extraction and Interpretation" und in IEEE Trans. on electron devices, vol. 45, no. 6, June 1998, "A Novel Singel-Devica DC Method for Extraction of the Effectlve Mobility and Source-Drain Resistances of Fresh and Hot-Carrier Degraded Drain-Engineered MOSFET's" offenbart.

Aus der DE 195 36 523 ist ein Verfahren zur Herstellung einer Gateelektrode in einer integrierten Schaltung bekannt. Dabei wird auf einem Substrat ein Gateoxid erzeugt, eine Hilfsschicht abgeschieden und an der Stelle, an der die Gateelektrode erzeugt werden soll, strukturiert. Eine Schicht eines Materials, das die Gateelektrode bildet, wird abgeschieden und aus dieser Schicht wird ein Spacer geätzt. Nachfolgend wird die Hilfsschicht entfernt und der Spacer als Gateelektrode verwendet. Dies soll die Herstellung von sublithographlschen Strukturen ermöglichen. Die Größe des Spacers und damit der Gateelektrode hängt von der Dickenschwankung der abgeschiedenen Schicht ab.

Die zur Spacerbildung und Gateelektrodenherstellung verwendete Schicht besteht aus Polysilizium. Auf das Gateoxid wird zunächst eine dünne Schicht Polysilizium mit einer Dicke von ca. 100 nm aufgebracht. Diese dient als Ätzstopp bei der Entfernung der Hilfsschicht, die üblicherweise aus CVD-Oxid besteht, um das unter der Polysiliziumschicht liegenden Gateoxid zu schützen. Die Verwendung von Plasma-CVD im Abscheide- oder Ätzmode ist besonders bevorzugt, da dadurch das Verfahren auch bei niedrigen Temperaturen von ungefähr 400° C angewandt werden kann.

In der DE 195 36 523 wird auf einem Siliziumsubstrat in einem Vorprozess ein Gateoxid erzeugt. Im nächsten Schritt wird eine dünne Polysiliziumschicht von ca. 100 nm abgeschieden. Diese kann im Plasma-CVD-Verfahren abgeschieden werden. Im nächsten Schritt wird eine relativ dicke Oxidschicht mit einer Dicke von ca. 0,5 bis 1 µm abgeschieden. Dies erfolgt ebenfalls im CVD-Verfahren (chemical vapor deposition). Die Oxidschicht wird im nächsten Schritt fotolithographisch strukturiert, wobei insbesondere die Stellen strukturiert werden, an denen das Gate erzeugt werden soll. An den Flanken der so strukturierten Oxidschicht werden Spacer durch konforme Abscheidung einer Polysiliziumschicht und anschließende anisotrope Ätzung erzeugt.

Der Erfindung liegt die Aufgabe zu Grunde einen Feldeffekttransistor mit einer LDD-Struktur insbesondere hinsichtlich eines möglichst verringerten Einschaltwiderstandes weiter zu entwickeln.

Diese Aufgabe wird erfindungsgemäß durch ein Verfahren mit den Merkmalen des Anspruchs 9 und durch einen Feldeffekttransistor mit den Merkmalen des Anspruchs 1 gelöst. Bevorzugte Weiterbildungen der Erfindung sind Gegenstand von Unteransprüchen.

Demzufolge erfolgt die Lösung der Aufgabe durch einen Feldeffekttransistor mit einem Gate-Oxld, einer, auf dem Gate-Oxid aufgebrachten polykristallinen Schicht und zumindest einem Spacer aus polykristallinem Silizium.

Das Gate-Oxid weist eine erste Dicke in einem ersten Bereich unterhalb der polykristallinen Siliziumschicht auf. Weiterhin weist das Gate-Oxid eine zweite Dicke in einem zweiten Bereich unterhalb des zumindest einen Spacers auf. Die zweite Dicke des Gate-Oxids ist in dem zweiten Bereich gegenüber der ersten Dicke des Gate-Oxids in dem ersten Bereich reduziert.

Der erste Bereich und der zweite Bereich grenzen dabei unmittelbar aneinander, so dass eine durchgehende Gate-Oxid-Schicht mit unterschiedlichen Dickenbereichen entsteht. In dem Übergangsbereich zwischen dem ersten Bereich und dem zweiten Bereich des Gate-Oxids weist das Gate-Oxid eine geglättete Stufe auf. Das Gate-Oxid weist vorteilhafterweise Siliziumdioxid auf.

Gemäß einer bevorzugten Weiterbildung der Erfindung ist zwischen einem hochdotierten Drain-Halbleitergebiet mit einer Dotierung eines ersten Leitungstyps und einem Kanalgebiet mit einer Dotierung eines zweiten Leitungstyps ein niedriger als das Drain-Halbleitergebiet dotiertes Halbleitergeblet (LDD) mit einer Dotierung des ersten Leitungstyps ausgebildet. Die geglättet Stufe zwischen dem ersten Bereich und dem zweiten Bereich des Gate-Oxids ist dabei im Bereich des niedriger dotierten Halbleitergebletes (LDD) an dieses angrenzend. Zudem kann auch ein hochdotiertes Source-Halbleitergebiet vorgesehen sein, dass an ein niedriger als das Source-Halbleitergebiet dotiertes weiteres Halbleitergebiet grenzt, so dass vorzugsweise eine symmetrische Struktur des Feldeffekttransistors ausgebildet ist.

Gemäß einer bevorzugten Weiterbildung der Erfindung Ist das niedriger als das Drain-Halbleitergebiet dotierte Halbleitergebiet (LDD) unterhalb eines Übergangs zwischen dem ersten Bereich des Gate-Oxids und dem zweiten Bereich des Gate-Oxids ausgebildet ist. Dabei ragt das nieder dotierte Halbleitergebiet vorteilhafterweise mindestens 10 nm, bevorzugt mindestens 50 nm, unterhalb des ersten Bereichs des Gate-Oxids mit der ersten Dicke.

Bevorzugt ist die polykristalline Siliziumschicht mit dem zumindest einen Spacer leitend verbunden. Dabei dient die polykristalline Siliziumschicht weiterhin als Gateelektrode. Die leitende Verbindung kann beispielsweise über eine weitere polykristalline Schicht erfolgen. Diese kann für eine Wlderstandsfunktion eine niedrigere Dotierung als die polykristalline Schicht aufweisen. Eine bevorzugte Weiterbildung der Erfindung sieht vor, dass der zumindest eine Spacer über eine Silizidschicht und/oder eine Metallschicht elektrisch angeschlossen ist. Es ist vorteilhaft, dass die Silizidschicht und/oder die Metallschicht der Spacer mit dem Gate-Anschluss leitend verbunden sind, so dass die Spacer besonders niederohmig anschließbar sind.

Die Spacer aus polykristallinem Silizium können beispielsweise hochohmig ausgebildet sein, Indem diese niedrig dotiert oder intrinsisch sind. Ist der Gate-Anschluss mit einem weiteren Transistor verbunden würde eine hochohmige Ausbildung eine kapazitive Lastwirkung eines Gate-Oxid-Kapazitätsanteils im zweiten Bereich des Gate-Oxids unterhalb der Spacer reduzieren.

Zwar ist es möglich, da sowohl die polykristalline Siliziumschicht als auch Spacer leitfähig sind, dass diese Siliziumschicht und die Spacer über eine Grenzfläche miteinander leitend verbunden sind. In einer vorteilhaften Weiterbildung der Erfindung ist hierzu alternativ oder in Kombination vorgesehen, dass der zumindest eine Spacer über die Silizidschicht und/oder über die Metallschicht mit der polykristallinen Siliziumschicht leitend, insbesondere niederohmig, verbunden ist. Auch ist es im Falle der ohmschen Verbindung über die Silizidschicht und/oder die Metallschicht nicht nötig eine zwischen der polykristallinen Siliziumschicht und den Spacern entstandene Oxidschicht, beispielsweise natives Siliziumdioxid zu entfernen.

Vorteilhafterweise ist die zweite Dicke des Gate-Oxids im zweiten Bereich gegenüber der ersten Dicke des Gate-Oxids im ersten Bereich um zumindest ein Drittel reduziert. Bevorzugt ist die zweite Dicke gegenüber der ersten Dicke des Gate-Oxids jedoch um zumindest eine Hälfte reduziert.

In einer vorteilhaften Ausgestaltung der Erfindung ist vorgesehen, dass der Drain-seitige PN-Übergang unterhalb des ersten Bereichs des Gate-Oxids ausgebildet. Auch ist es vorteilhaft den Source-seitigen PN-Übergang unterhalb des ersten Bereichs des Gate-Oxids auszubilden.

Weiterhin wird die erfindungsgemäße Aufgabe durch ein Verfahren zur Herstellung eines Feldeffekttransistors gelöst. In diesem Verfahren wird auf einer Halbleiteroberfläche, vorteilhafterweise eines <100>-orientierten Siliziumsubstrats, ein erster Bereich eines Gate-Oxids durch Oxidation erzeugt. Auf dem Gate-Oxid wird eine polykristalline Siliziumschicht aufgebracht und strukturiert. Außerhalb der strukturierten, polykristallinen Siliziumschicht wird das freiliegende Gate-Oxid, insbesondere durch einen Ätzprozess, entfernt.

Außerhalb der strukturierten, polykristallinen Siliziumschicht wird ein zweiter Bereich des Gate-Oxids mit einer geringeren Oxiddicke als im ersten Bereich des Gate-Oxids, insbesondere durch Trockenoxidation, erzeugt. Vorzugsweise wirkt die polykristalline Siliziumschicht dabei als Maskierung für die Trockenoxidation im zweiten Bereich. Mit der Trockenoxidation können ebenfalls nicht maskierte Oberflächen der strukturierten, polykristallinen Siliziumschicht, insbesondere deren Seitenflächen oxidiert werden. Auf dem zweiten Bereich des Gate-Oxids wird zumindest ein Spacer aus polykristallinem Silizium, insbesondere durch Aufbringen und Ätzen von polykristallinem Silizium, erzeugt. Beispielsweise wird dieser durch vorheriges Entfernen des Oxids an den Seitenflächen der polykristallinen Siliziumschicht mit dieser leitend verbunden.

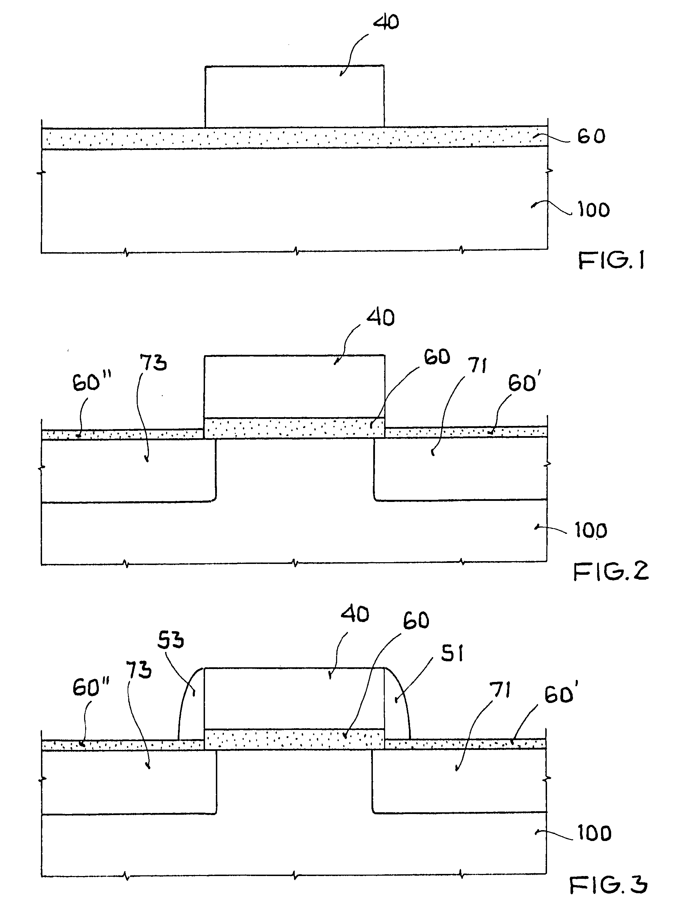

Im Folgenden wird die Erfindung in einem Ausführungsbeispiel anhand einer Zeichnung mit den Figuren 1 bis 5 näher erläutert. Dabei zeigen die Figuren 1 bis 5 schematische Schnittansichten nach Prozessschritten zur Herstellung eines Feldeffekttransistors. Es sind nicht alle Details des Herstellungsprozesses dargestellt. Diese Details sind in der Mehrzahl Standard-Fabrikationsprozesse eines LDD (Lightly Doped Drain)-MOSFETs.

In Fig. 5 ist ein im Wesentlichen fertiger Feldeffekttransistor schematisch in Schnittansicht dargestellt. Es fehlen beispielsweise noch Metallisierungsebenen zur Verbindung der Anschlüsse (G, D, S) des Feldeffekttransistors. Der Aufbau des Feldeffekttransistors weist die Anschlüsse Gate G (Tor), Drain D (Senke) und Source S (Quelle) auf. Der Drain-Anschluss D ist dabei erzeugt, indem eine Oberfläche des Drain-Halbleitergebietes 81 beispielsweise zu einer TiSi₂―Schicht 91 silizidiert ist. Der Source-Anschluss S Ist dabei erzeugt, indem eine Oberfläche der Source-Halbleitergebietes 83 beispielsweise zu einer TiSi₂-Schicht 93 silizidiert Ist.

Das Drain-Halbleitergebiet 81 und das Source-Halbleitergebiet weisen dabei eine hohe Dotierstoffkonzentration mit einem Dotierstoff eines ersten Leitungstyps auf. Die Halbleitergebiete 71 und 73 weisen hingegen eine gegenüber dem Drain-Halbleitergebiet 81 und dem Source-Halbleitergebiet 83 signifikant geringere Dotierstoffkonzentration auf. Diese werden auch als LDD-Strukturen bezeichnet, wobei der Dotierstoff in der LDD-Struktur denselben Leitungstyp aufweist, wie der Dotierstoff im Drain-Halbleitergebiet 81.

Ein Halbleitergeblet 100 aus monokristallinem Silizium weist die Dotierstoffkonzentration eines Substrates oder einer Wanne auf, wobei ein Dotierstoff im Halbleitergebiet 100 des Substrates oder der Wanne einen, dem ersten Leitungstyp entgegen gesetzten zweiten Leitungstyp aufweist. Wird an das Gate G eine Spannung größer als eine Schwellspannung (Threshold) angelegt, bildet sich unter einem Gate-Oxid 60 in diesem in einem Kanalgeblet 100' des Substrates 100 des zweiten Leitungstyps ein leitender Kanal aus, so dass ein Stromfluss zwischen dem Draln-Anschluss D und dem Source-Anschluss S ermöglicht wird. Demzufolge wird das Halbleitergebiet 100 unterhalb des Gate-Oxids 60 auch als Kanalgebiet 100' bezeichnet.

Oberhalb des Gate-Oxids 60 ist eine polykristalline Siliziumschicht 40 ausgebildet, die zum Anschluss ebenfalls silizidiert ist. Seitlich an diese polykristalline Sillziumschicht 40 angrenzend sind zwei Spacer 51 und 53 aus polykristallinem Silizium ausgebildet. Diese Spacer sind zum Anschluss ebenfalls silizidiert. Dabei können die Spacer 51, 53 über die Silizidschicht 92 mit der polykristallinen Siliziumschicht 40 elektrisch leitend verbunden sein.

Das Gate-Oxid 60 weist einen ersten Bereich 62 auf, In dem das Gate-Oxid 60 eine erste Dicke aufweist. Das Gate-Oxid 60', 60" weist einen zweiten Bereich 61, 63 auf, In dem das Gate-Oxid 60', 60" eine zweite Dicke aufweist. Die zweite Dicke ist dabei gegenüber der ersten Dicke reduziert. Die Dicken-Reduktion beträgt vorteilhafterweise mehr als ein Drittel vorzugsweise mehr als die Hälfte der ersten Dicke des Gate-Oxids 60. Das Gate-Oxid 60, 60', 60" ist aus Siliziumdioxid gebildet. Das Gate-Oxid 60, 60', 60" ist dabei einstückig ausgebildet.

Die polykristalline Siliziumschicht 40 ist oberhalb des ersten Bereichs 62 mit der ersten Dicke des Gate-Oxids 60 ausgebildet. Die polykristallinen Spacer 51, 53 sind hingegen oberhalb des zweiten Bereichs 61, 63 mit der zweiten Dicke des Gate-Oxids 60', 60" ausgebildet. Im dargestellten Ausführungsbeispiel ist das Gate-Oxid 60', 60" über den Spacer 51, 53 hinaus bis zur Sillzidschicht 91, 93 ausgebildet.

Das geringer dotierte LDD-Gebiet 71 weist einen ersten Halbleiterbereich 711 unterhalb des Spacers 51 und damit unterhalb des zweiten Bereichs 61 des Gate-Oxids 60' auf. Ein zweiter Halbleiterbereich 712 des LDD-Gebietes 71 ist unterhalb der polykristallinen Siliziumschicht 40 und damit unterhalb des ersten Bereichs 62 des Gate-Oxids 60 ausgebildet. Analog weist das geringer dotierte LDD-Gebiet 73 einen ersten Halbleiterbereich 733 unterhalb des Spacers 53 und damit unterhalb des zweiten Bereichs 63 des Gate-Oxids 60" auf. Ein zweiter Halbleiterbereich 732 des LDD-Gebietes 73 ist unterhalb der polykristallinen Siliziumschicht 40 und damit unterhalb des ersten Bereichs 62 des Gate-Oxids 60 ausgebildet. Demzufolge sind die PN-Übergänge Im Kanalbereich unterhalb des ersten Bereichs 62 des Gate-Oxlds 60 ausgebildet.

Eine Länge der polykristallinen Siliziumschicht 40 des Feldeffekttransistors des In Fig. 5 dargestellten Ausführungsbeispiels ist 0,25 µm. Die Dotierstoffkonzentration im LDD-Gebiet 71, 73 beträgt 1 e18 cm⁻³. Die Dotierstoffkonzentration im Kanalgebiet beträgt 1 e17 cm⁻³. Die Dotierstoffkonzentration im Drain-Halbleitergebiet 81, im Source-Halbleitergebiet 83 und in der polykristallinen Gate-Siliziumschicht 40 beträgt 1 e20 cm⁻³. Die Dotierstoffkonzentration in den Spacern kann beispielsweise der in der polykristallinen Gate-Siliziumschicht 40 entsprechen oder vorteilhafterweise für eine hochohmige Ausbildung der Spacergebiete 51, 53 1e16 cm⁻³ oder weniger betragen.

Das LDD-Geblet 71, 73 ist beidseitig 50nm unter den ersten Bereich 62 des Gate-Oxids 60 und damit etwa 50nm unter die polykristalline Siliziumschicht 40 lateral diffundiert. Die Gate-Länge beträgt dabei 0,15 µm. Die Weite der der polykristallinen Spacer 53, 51 beträgt 75 nm. Die erste Dicke des Gate-Oxids 60 unterhalb der polykristallinen Siliziumschicht 40 beträgt 16 nm, die zweite Dicke des Gate-Oxids 60', 60" unterhalb der polykristallinen Spacer 51, 53 beträgt 8 nm. Mit dieser Spezifikation weist der Feldeffekttransistor der Flg. 5 gegenüber einem Feldeffekttransistor mit Spacern aus Dielektrikum eine verbesserte Zuverlässigkeit und eine verbesserte Durchbruchspannung auf. Der Einschaltwiderstand und die Transkonduktanz sind ebenfalls signifikant verbessert. Dies wird erzielt, Indem das an die Spacer 51, 53 angelegte Potential unmittelbar unterhalb des Gate-Oxids 60', 60" eine Anreicherung von Ladungsträgern bewirkt.

In den Figuren 1 bis 5 sind zudem Zustände während des Herstellungsprozesses des Feldeffekttransistors als Schnittansicht schematisch dargestellt. Dabei sind im Folgenden nur die wichtigsten Verfahrensschritte genannt. Beispielsweise Reinigungsschritte, sowie das Aufbringen und entfernen von Maskierungen mittels Fotolack sind zur vereinfachten Darstellung fortgelassen.

In Prozessschrltten wird auf einem vorteilhafterweise monokristallinen Substrat 100 ein Gate-Oxid 60 einer ersten Dicke durch Trockenoxidation erzeugt. Nachfolgend wird eine Schicht 40 aus polykristallinen Silizium aufgebracht und durch eine Maskierung strukturiert. Dieser Verfahrenszustand ist in Fig. 1 schematisch dargestellt.

In nachfolgenden Schritten wird das Gate-Oxid 60 außerhalb eines Bereichs, der durch die strukturierte, polykristalline Siliziumschicht 40 bedeckt ist, entfernt, Indem beispielsweise ein bezüglich des Gate-Oxids 60 selektiv wirkendes Ätzmittel verwendet wird. Anschließend erfolgt eine erneute Trockenoxidation des Substrats 100. Mit der erneuten Trockenoxidation wird das Gate-Oxid 60', 60" mit einer reduzierten Dicke außerhalb der polykristallinen Siliziumschicht 40 erzeugt. Außerdem wird durch polykristalline Siliziumschicht 40 maskiert ein Dotierstoff in das Substrat 100 eingebracht, vorzugsweise implantiert. Dabei kann die Implantation vor oder nach der Ausbildung des Gate-Oxids 60', 60" mit der reduzierten Dicke erfolgen. Mit dieser Implantation wird der Dotierstoff für die LDD-Strukturen 71, 73 eingebracht. Der resultierende Prozesszustand ist in Fig. 2 dargestellt.

Alternativ zur erneuten Trockenoxidation des Substrats 100 kann auch das vorhandene Gate-Oxid 60 außerhalb der Bedeckung durch die polykristalline Siliziumschicht 40 teilweise abgeätzt werden. Hierzu wird beispielsweise HF oder ein anderes Nassätzmittel verwendet. Die Ätzung erfolgt dabei beispielsweise auf Zeit.

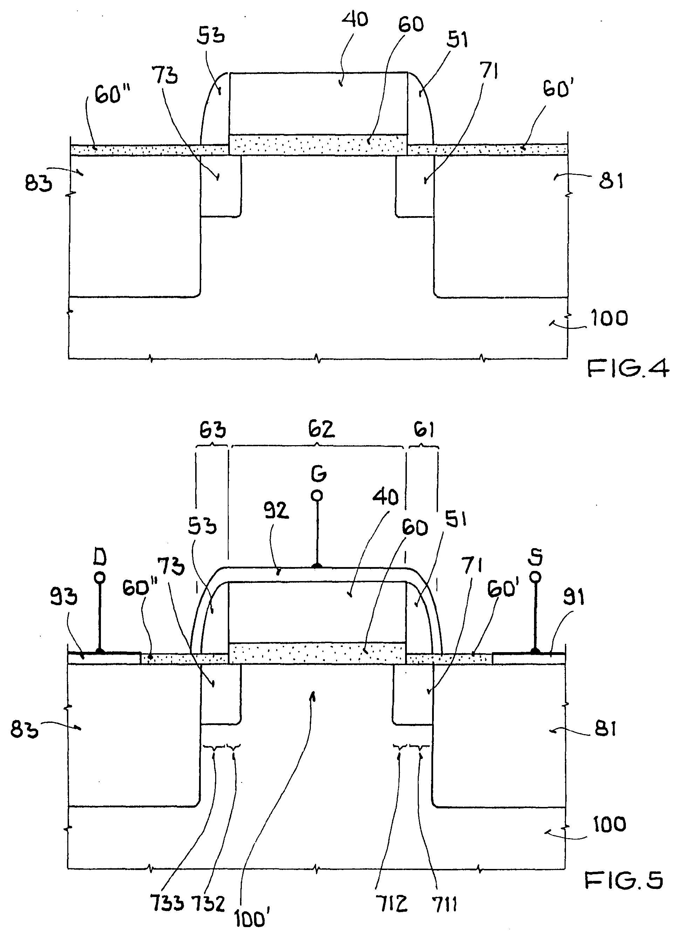

In Fig. 3 sind an die Kanten der polykristallinen Siliziumschicht 40 Spacer 51, 53 aus polykristallinem Silizium ausgebildet. Nachfolgend wird, wie in Fig. 4 gezeigt mit einer hohen Dosis ein Dotierstoff In das Source-Halbleitergebiet 83, in das Drain-Halbleitergebiet 81 und in die polykristalline Siliziumschicht 40 implantiert. Sofern die Spacer 51, 53 keine Maskierung aufweisen wird eine hohe Dosis des Dotierstoffs ebenfalls in die Spacer 51, 53 implantiert. Ist dies nicht erwünscht, um zum Beispiel die Spacer hochohmig auszubilden, ist eine Maskierung, beispielsweise aus Siliziumnitrid erforderlich, die am Ende des Herstellungsprozesses der Spacer 51, 53 aufgebracht werden kann.

Gemäß Fig. 5 werden nachfolgend das Source-Halbleitergebiet 83 und das Drain-Halbleitergebiet 81 an deren Oberfläche freigelegt und der Wafer mit einer Metallschicht beschichtet. In einem nachfolgenden Silizidierungsprozess werden die Grenzflächen zwischen Silizium und dem angrenzenden Metall zu einer oder mehreren Silizidschichten 91, 92, 93 silizldiert.

### Bezugszelchenliste

- 100: Substrat, Wanne
- 100': Kanalgebiet des Substrats/der Wanne
- 40: polykristalline Siliziumschicht des Gates
- 51,53: Spacer, Seitenwand-Abstandshalter
- 60: Gate-Oxid mit einer ersten Dicke
- 60', 60": Gate-Oxid mit einer zweiten Dicke
- 62: erster Bereich des Gate-Oxids
- 61, 63: zweiter Bereich des Gate-Oxids
- 71, 73: LDD-Gebiet, niedrig dotiertes Halbleitergebiet
- 711, 733: erster Halbleiterbereich des LDD-Gebietes
- 712, 732: zweiter Halbleiterbereich des LDD-Gebietes
- 81: Drain-Halbleitergebiet
- 83: Source-Halbleitergebiet
- 91, 92, 93: Silizidschicht, TiSi₂-Schicht
- G: Gate-Anschluss (Tor)
- D: Drain-Anschluss (Senke)
- S: Source-Anschluss (Quelle)

## Patentansprüche

1. Feldeffekttransistor mit
- einem Gate-Oxid (60, 60', 60")
- einer auf dem Gate-Oxid (60) aufgebrachten polykristallinen Schicht (40), und
- zumindest einem Spacer (51, 53) aus polykristallinem Silizium,
bei dem
- der zumindest eine Spacer (51, 53) mit der auf dem Gate-Oxid (60) aufgebrachten polykristallinen Schicht (40) leitend verbunden ist,
- das Gate-Oxid (60) eine erste Dicke in einem ersten Bereich (62) unterhalb der polykristallinen Siliziumschicht (40) und eine zweite Dicke in einem zweiten Bereich (61, 63) unterhalb des zumindest einen Spacers (51, 53) aufweist, und
- die zweite Dicke des Gate-Oxids (60', 60") In dem zweiten Bereich (61, 63) gegenüber der ersten Dicke des Gate-Oxids (60) in dem ersten Bereich (62) reduziert ist.

2. Feldeffekttransistor nach Anspruch 1, bei dem zwischen einem hochdotierten Drain-Halbleitergebiet (81) mit einer Dotierung eines ersten Leitungstyps und einem Kanalgebiet (100') mit einer Dotierung eines zweiten Leitungstyps ein niedriger als das Drain-Halbleitergebiet (81) dotiertes Halbleitergebiet (71) mit einer Dotierung des ersten Leitungstyps ausgebildet ist.

3. Feldeffekttransistor nach einem der vorhergehenden Ansprüche, bei dem das niedriger als das Drain-Halbleitergebiet (81) dotierte Halbleitergebiet (71) unterhalb eines Übergangs zwischen dem ersten Bereich (62) und dem zweiten Bereich (61) ausgebildet ist.

4. Feldeffekttransistor nach einem der vorhergehenden Ansprüche, bei dem der zumindest eine Spacer (51, 53) und die polykristalline Siliziumschicht (40) über eine Grenzfläche miteinander leitend verbunden sind.

5. Feldeffekttransistor nach einem der vorhergehenden Ansprüche, bei dem der zumindest eine Spacer (51, 53) über eine Silizidschicht (92) und/oder über eine Metallschicht mit der polykristallinen Siliziumschicht (40) leitend verbunden ist.

6. Feldeffekttransistor nach einem der vorhergehenden Ansprüche, bei dem die zweite Dicke gegenüber der ersten Dicke um zumindest ein Drittel, vorzugsweise um zumindest eine Hälfte reduziert ist.

7. Feldeffekttransistor nach einem der vorhergehenden Ansprüche, bei dem der Drain-seitige PN-Übergang unterhalb des ersten Bereichs (62) des Gate-Oxids (60) ausgebildet ist.

8. Feldeffekttransistor nach einem der vorhergehenden Ansprüche, bei dem der Source-seitige PN-Übergang unterhalb des ersten Bereichs (62) des Gate-Oxids (60) ausgebildet ist.

9. Verfahren zur Herstellung eines Feldeffekttransistors, indem
- auf einer Halbleiteroberfläche ein erster Bereich (62) eines Gate-Oxlds (60) durch Oxidation erzeugt wird,
- auf dem Gate-Oxid (60) eine polykristalline Sillzlumschicht (40) aufgebracht und strukturiert wird,
- außerhalb der strukturierten, polykristallinen Siliziumschicht (40) das freiliegende Gate-Oxid (60) entfernt wird,
- außerhalb der strukturierten, polykristallinen Siliziumschicht (40) ein zweiter Bereich (61, 63) des Gate-Oxids (60', 60") mit einer geringeren Oxiddicke als im ersten Bereich (62) des Gate-Oxids (60) erzeugt wird, und
- auf dem zweiten Bereich (61, 63) des Gate-Oxids (60', 60") zumindest ein Spacer (51, 53) aus polykristallinem Silizium erzeugt und mit der polykristallinen Siliziumschicht leitend verbunden wird.
